# EUROPEAN PATENT SPECIFICATION

(11) **EP 3 945 730 B1**
(45) Date of publication and mention of the grant of the patent: **18.12.2024**
(21) Application number: 21153188.4
(22) Date of filing: 25.01.2021
(51) Int. Cl.: H04R 9/06, H04R 9/04

(54) **SPEAKER ASSEMBLY AND DISPLAY DEVICE COMPRISING IT**
LAUTSPRECHERANORDNUNG UND ANZEIGEVORRICHTUNG DAMIT
ENSEMBLE HAUT-PARLEUR ET DISPOSITIF D'AFFICHAGE LE COMPRENANT

(30) Priority: 28.07.2020 KR 20200093827
(43) Date of publication of application: 02.02.2022
(73) Proprietor: LG Electronics Inc., Seoul 07336 (KR)
(72) Inventor: LEE, Sangkeun, Seoul 08592 (KR); YOUN, Hyunseung, Seoul 08592 (KR); JE, Yongjun, Seoul 08592 (KR); SONG, Genmoo, Seoul 08592 (KR)
(74) Representative: Vossius & Partner Patentanwälte Rechtsanwälte mbB

(56) References cited:
- EP-A1- 1 950 998
- JP-A- 2002 176 693
- JP-A- 2002 223 495
- JP-U- S5 723 694
- JP-U- S5 734 776
- US-A1- 2003 103 642
- US-A1- 2009 257 617
- US-A1- 2018 146 294
- US-B1- 10 469 954

## Description

### BACKGROUND OF THE INVENTION

### 1. Field of the invention

The present disclosure relates to a speaker assembly, and a display device including the same.

### 2. Description of the Related Art

With the development of information society, there are increasing demands for various types of display devices. In order to meet such demands, various display devices have been developed and used, including a Liquid Crystal Display (LCD), a Plasma Display Panel (PDP), an Electro luminescent Display (ELD), a Vacuum Fluorescent Display (VFD), an Organic Light Emitting Diode (OLED), and the like.

Among these devices, the OLED display devices have effects in that in comparison with the LCD devices, the OLED display devices are excellent in brightness and viewing angle characteristics and require no backlight unit, such that the OLED display devices can be realized as ultra-thin displays.

Recently, many studies have been conducted on a speaker assembly which is suitable for use in the structure of the display devices and provides high sound quality.

US 2009/257617 A1 discloses a speaker and a voice coil unit.

### SUMMARY OF THE INVENTION

It is an object of the present disclosure to solve the above and other problems.

It is another object of the present disclosure to provide a speaker assembly capable of providing high sound quality.

It is yet another object of the present disclosure to provide a speaker assembly having a slim structure while maintaining a high sound pressure level.

It is still another object of the present disclosure to provide a speaker assembly capable of increasing the amplitude of the speaker.

The invention is defined in the independent claims. Dependent claims describe preferred embodiments.

In accordance with an aspect of the present disclosure, the above and other objects can be accomplished by providing a speaker assembly according to claim 1 and a display device according to claim 7.

### BRIEF DESCRIPTION OF THE DRAWINGS

The above and other objects, features and other advantages of the present disclosure will be more clearly understood from the following detailed description taken in conjunction with the accompanying drawings, in which:

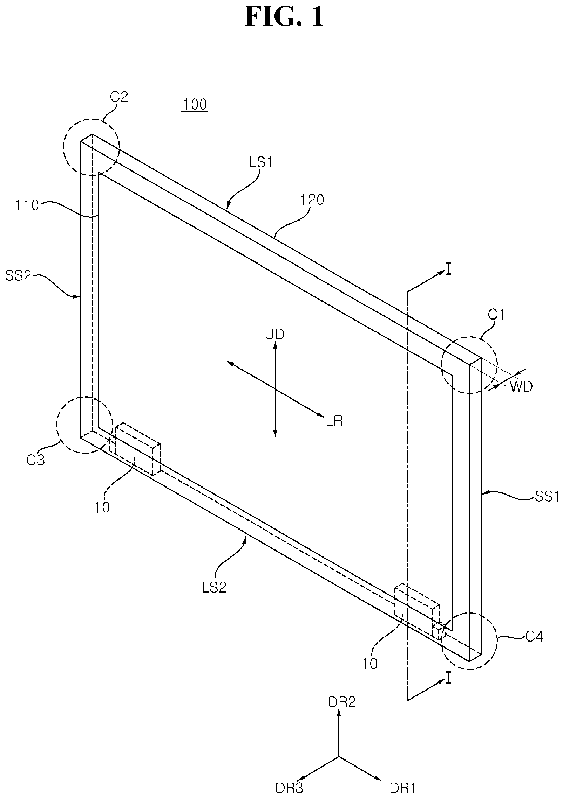

FIGS. 1 to 9 are diagrams illustrating examples of a speaker assembly, and a display device including the same, according to embodiments of the present disclosure.

### DETAILED DESCRIPTION OF THE PREFERRED EMBODIMENTS

Hereinafter, the present disclosure will be described in detail with reference to the accompanying drawings. In order to clearly and briefly describe the present disclosure, components that are irrelevant to the description will be omitted in the drawings. The same reference numerals are used throughout the drawings to designate the same or similar components, and a redundant description thereof will be omitted.

Terms "module" and "part" for elements used in the following description are given simply in view of the ease of the description, and do not carry any important meaning or role. Therefore, the "module" and the "part" may be used interchangeably. Descriptions of some well-known technologies that possibly obscure the disclosure will be omitted, if necessary. Further, the accompanying drawings are used to help easily understand various technical features and it should be understood that the embodiments presented herein are not limited by the accompanying drawings.

It will be understood that, although the terms first, second, etc., may be used herein to describe various elements, these elements should not be limited by these terms. These terms are only used to distinguish one element from another.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

As used herein, the singular forms are intended to include the plural forms as well, unless the context clearly indicates otherwise.

It should be understood that the terms "comprise", "include", "have", etc. when used in this specification, specify the presence of stated features, integers, steps, operations, elements, components, or combinations of them but do not preclude the presence or addition of one or more other features, integers, steps, operations, elements, components, or combinations thereof.

The following description of a display panel will be given by using an Organic Light Emitting Diode (OLED) as an example, but the display panel which may be applied to the present disclosure is not limited to the OLED panel.

Referring to FIG. 1, a display device 100 may include a first long side LS1; a second long side LS2 facing the first long side LS1; a first short side SS1 adjacent to the first long side LS1 and the second long side LS2; and a second short side SS2 facing the first short side SS1.

In the display device 100, an area of the first short side SS1 may be referred to as a first side area, and an area of the second short side SS2 may be referred to as a second side area facing the first side area. In the display device 100, an area of the first long side LS1 may be referred to as a third side area being adjacent to the first side area and the second side area, and being disposed between the first side area and the second side area; and an area of the second long side LS2 may be referred to as a fourth side area being adjacent to the first side area and the second side area, being disposed between the first side area and the second side area, and facing the third side area.

For convenience of explanation, FIG. 1 illustrates an example in which the length of the first and second long sides LS1 and LS2 is greater than the length of the first and second short sides SS1 and SS2, but the length of the first and second long sides LS1 and LS2 may be approximately equal to the length of the first and second short sides SS1 and SS2.

In the following description, a first direction DR1 is a direction parallel to the first and second long sides LS1 and LS2 of a display panel 110, and a second direction DR2 is a direction parallel to the first and second short sides SS1 and SS2 of the display panel 110. A third direction DR3 may be a direction perpendicular to the first direction DR1 and/or the second direction DR2.

A side or a surface, on which the display device 100 displays an image, may be referred to as a front side or a front surface. When the display device 100 displays the image, a side or a surface, at which the image may not be viewed, may be referred to as a back side or a back surface. When the display device 100 is viewed from the front side or the front surface, the first long side LS1 may be referred to as an upper side or an upper surface, and the second long side LS2 may be referred to as a lower side or a lower surface. When the display device 100 is viewed from the front side or the front surface, the first short side SS1 may be referred to as a right side or a right surface, and the second short side SS2 may be referred to as a left side or a left surface.

The first long side LS1, the second long side LS2, the first short side SS1, and the second short side SS2 may be referred to as edges of the display device 100. Further, positions where the first long side LS1, the second long side LS2, the first short side SS1, and the second short side SS2 meet each other may be referred to as corners. For example, a position where the first long side LS1 and the first short side SS1 meet each other may be referred to as a first corner C1; a position where the first long side LS1 and the second short side SS2 meet each other may be referred to as a second corner C2; a position where the second short side SS2 and the second long side LS2 meet each other may be referred to as a third corner C3; and a position where the second long side LS2 and the first short side SS1 meet each other may be referred to as a fourth corner C4.

A direction from the first short side SS1 to the second short side SS2 or a direction from the second short side SS2 to the first short side SS1 may be referred to as a left-right direction LR or a horizontal direction DR1. A direction from the first long side LS1 to the second long side LS2 or a direction from the second long side LS2 to the first long side LS1 may be referred to as an up-down direction UD or a vertical direction DR2.

Further, a direction from the front surface to the back surface or a direction from the back surface to the front surface may be referred to as a front-rear direction DR3 or a thickness direction. The front-rear direction DR3 may be a direction perpendicular to the left-right direction DR1 and/or the vertical direction DR2.

The display device 100 includes the display panel 110, a main frame 120, and a speaker assembly 10.

The display pane 110 may be provided on the front surface of the display device 100 and may display images.

The main frame 120 may be disposed at a rear portion of the display panel 110. The main frame 120 may be connected to the display panel 110.

The speaker assembly 10 is disposed adjacent to a lower end of the main frame 120 to be installed at the main frame 120. The speaker assembly 10 may direct sound downwardly of the display device 100.

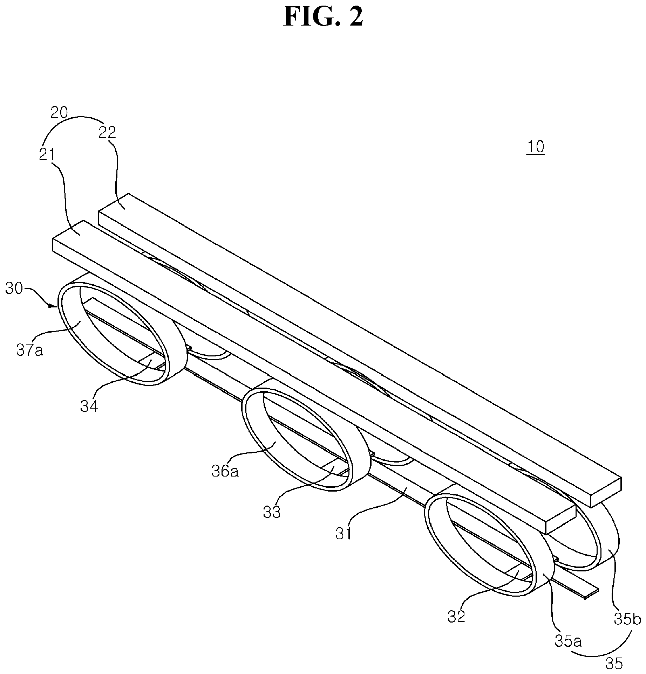

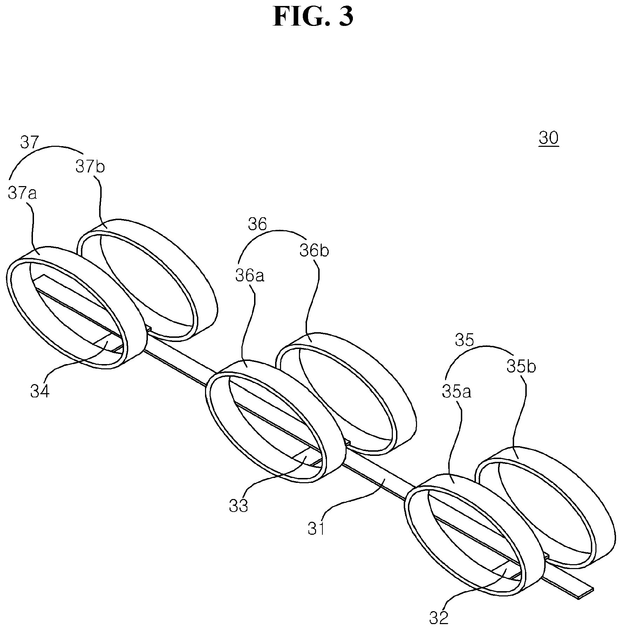

Referring to FIGS. 2 and 3, the plate 20 may be formed in the shape of a flat plate that extends long. For example, the plate 20 may be metal. In another example, the plate 20 may be a synthetic resin. The plate 20 may include a first plate 21 and a second plate 22. The first plate 21 may be parallel to the second plate 22 and may be spaced apart from the second plate 22. The plate 20 may be referred to as a rear plate 20.

An elastic member 30 may support the plate 20. The elastic member 30 may be connected or fixed to a lower part of the plate 20. The elastic member 30 may be referred to as a damper 30. The elastic member 30 includes a center plate 31, bridges 32, 33, and 34, and circles 35, 36, and 37. For example, the elastic member 30 may be metal. In another example, the elastic member 30 may be a synthetic resin.

The center plate 31 may extend long in a longitudinal direction of the plate 20 and may be disposed between the first plate 21 and the second plate 22. The center plate 31 may be spaced apart from the first plate 21 and the second plate 22 at a position below the first plate 21 and the second plate 22.

The bridges 32, 33, and 34 may be disposed in a direction intersecting a longitudinal direction of the center plate 31, and may extend across the center plate 31.

The circles 35, 36, and 37 facing each other may be connected or fixed to both ends of the bridges 32, 33, and In an example not falling within the scope of the claims, the circles 35, 36, and 37 may have an elliptical shape. The circles 35, 36, and 37 may have elasticity. Upper surfaces of the circles 35, 36, and 37 may come into contact with the plate 20.

The first bridge 32 may be disposed adjacent to one end of the center plate 31. A first circle 35a may be disposed on one end of the first bridge 32, and a second circle 35b may be disposed on the other end of the first bridge 32. The third bridge 34 may be disposed adjacent to the other end of the center plate 31. A fifth circle 37a may be disposed on one end of the third bridge 34, and a sixth circle 37b may be disposed on the other end of the third bridge 34. The second bridge 33 may be disposed between the first bridge 32 and the third bridge 34. The third circle 36a may be disposed on one end of the second bridge 36b, and the fourth circle 36b may be disposed on the other end of the second bridge 33. The circles 35, 36, and 37 may be connected or fixed to the bridges 32, 33, and 34.

The first circle 35a may face the second circle 35b with respect to the center plate 31, the third circle 36a may face the fourth circle 36b with respect to the center plate 31, and the fifth circle 37a may face the sixth circle 37b with respect to the center plate 31.

Accordingly, a range of motion of the damper 30 may be increased or maximized relative to the size of the speaker assembly 10. The range of motion of the damper 30 may correlate to a reproduction band of the speaker assembly 10, such that a sound reproduction band of the speaker assembly 10 may be improved. In addition, sound pressure of the speaker assembly 10 may also be improved.

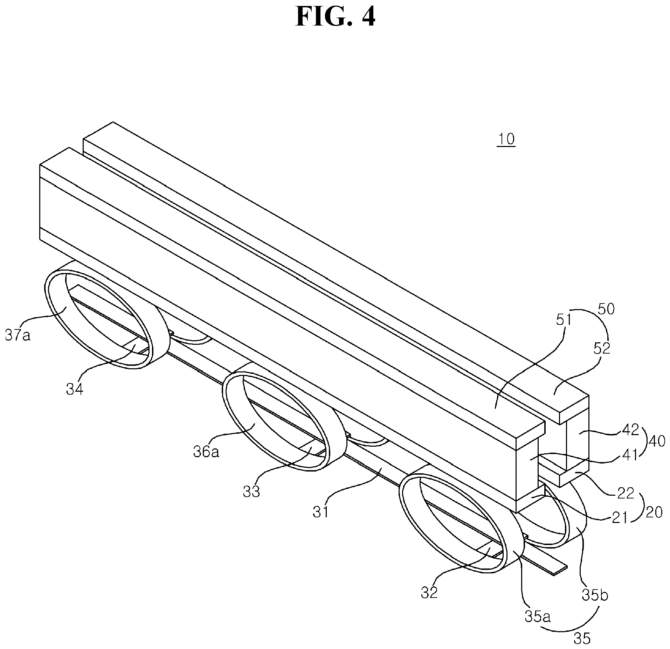

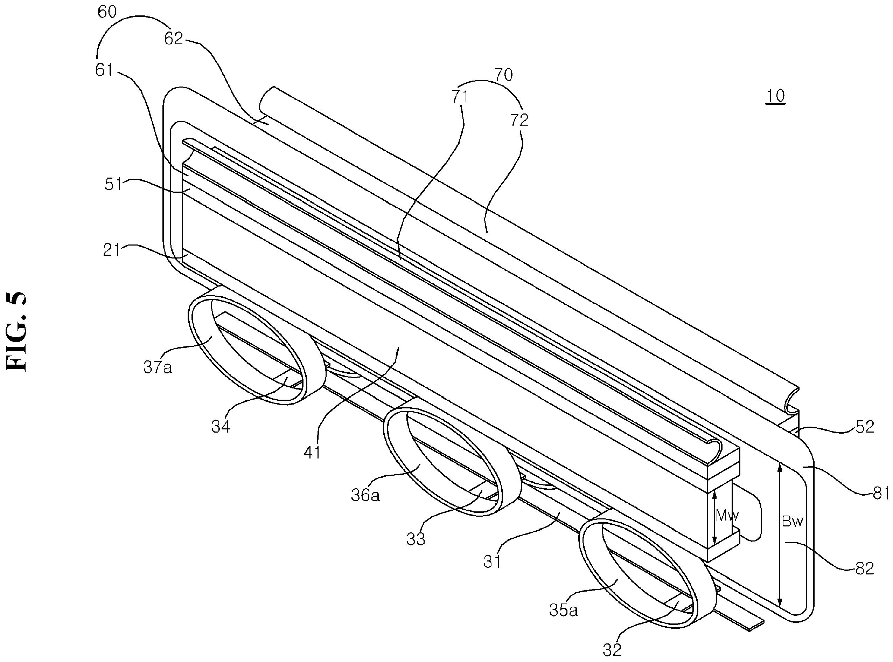

Referring to FIGS. 4 and 5, magnets 40 may be disposed on the rear plate 20. The magnets 40 may have a square column shape that extends long. A first magnet 41 may be connected or fixed to an upper portion of the first rear plate 21, and a second magnet 42 may be connected or fixed to an upper portion of the second rear plate 22. The first magnet 41 may face the second magnet 42 with respect to the center plate 31.

A plate 50 may extend long. The plate 50 may be connected or fixed to an upper portion of the magnets 40. The plate 50 may be referred to as a front plate 50. A first front plate 51 may be disposed on the first magnet 41, and the second front plate 52 may be disposed on the second magnet 42. The first front plate 51 may face the first rear plate 21 with respect to the first magnet 41. The second front plate 52 may face the second rear plate 22 with respect to the second magnet 42.

A bobbin 81 is formed in the shape of a flat plate that extends long. For example, the bobbin 81 may be a printed circuit board (PCB). A voice coil 82 may be wound around the bobbin 81. The voice coil 82 may be wound around the bobbin 81 to form a closed-loop. For example, the voice coil 82 may be printed on the bobbin 81. A vertical width Bw of the voice coil 82 may be greater than a vertical width Mw of the magnets 40. The bobbin 81 is disposed between the first magnet 41 and the second magnet 42. When a current flows through the voice coil 82, the bobbin 81 may move in a vertical direction. A lower end of the bobbin 81 may be connected or fixed to the center plate 31.

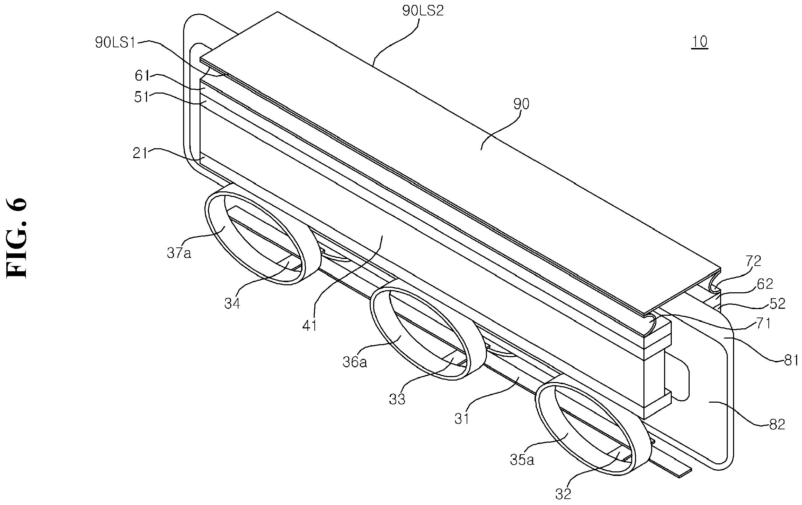

Referring to FIGS. 5 and 6, a frame 60 may be formed in the shape of a flat plate that extends long. The frame 60 may be connected or fixed to an upper portion of the front plate 50. A first frame 61 may be disposed on the first front plate 51, and a second frame 62 may be disposed on the second front plate 52.

A speaker edge 70 may be connected or fixed to an upper portion of the frame 60. The speaker edge 70 may have elasticity. The speaker edge 70 may be formed in the shape of a cylinder that extends long. The speaker edge 70 may be formed in the shape of a cylinder cut in half. For example, the speaker edge 70 may have a U-shaped cross-section. A first speaker edge 71 may be connected or fixed to an upper portion of the first frame 61, and a second speaker edge 72 may be connected or fixed to an upper portion of the second frame 62. The first speaker edge 71 may be convex toward the second speaker edge 72, and the second speaker edge 72 may be convex toward the first speaker edge 71.

A diaphragm 90 may be formed in the shape of a plate that extends long. The diaphragm 90 may be fixed to an upper end of the bobbin 81. One long side 90LS1 of the diaphragm 90 may be connected or fixed to the first speaker edge 71, and the other long side 90LS2 of the diaphragm 90 may be connected or fixed to the second speaker edge 72. Accordingly, an area of the diaphragm 90 may be maximized relative to a thickness of the speaker assembly 10, and sound pressure may be improved.

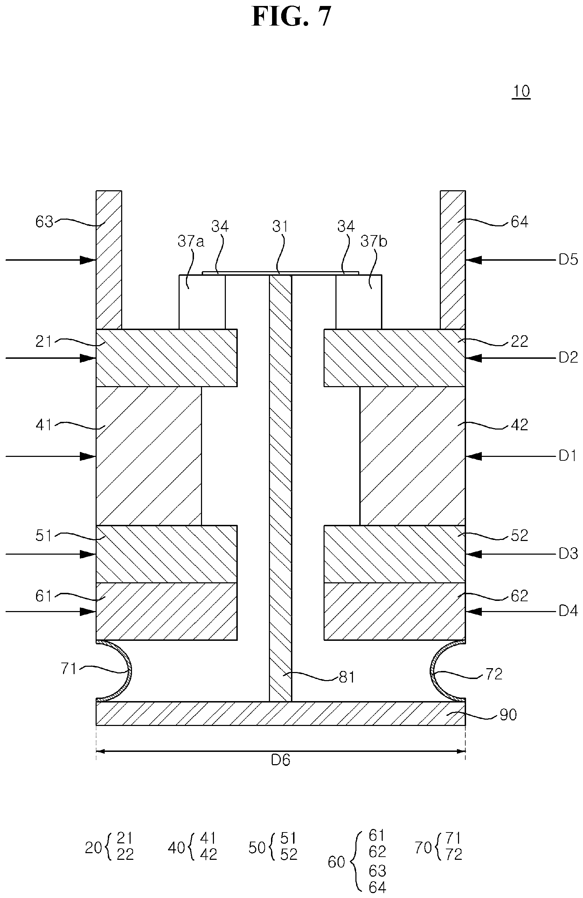

Referring to FIG. 7, an outer surface of the first magnet 41 and an outer surface of the second magnet 42 may be exposed to the outside of the speaker assembly 10. For example, a first distance D1 from the outer surface of the first magnet 41 to the outer surface of the second magnet 42 may be the thickness of the speaker assembly 10. Outer surfaces of the plates 20 and 60 may be aligned with respect to the outer surfaces of the magnets 40. The outer surfaces of the frames 60 may be aligned with respect to the outer surfaces of the magnets 40.

A second distance D2 between an outer surface of the first rear plate 211 and an outer surface of the second rear plate 22 may be substantially equal to the first distance D1. A third distance D3 between an outer surface of the first front plate 51 and an outer surface of the second front plate 52 may be substantially equal to the first distance D1.

A fourth distance D4 between an outer surface of the first front frame 61 and an outer surface of the second front frame 62 may be substantially equal to the first distance D1. A fifth distance D5 between an outer surface of the first rear frame 63 and an outer surface of the second rear frame 64 may be substantially equal to the first distance D1.

A sixth distance D6 between one long side of the diaphragm 90 and the other long side of the diaphragm 90 may be substantially equal to the first distance D1. The sixth distance D6 may be substantially equal to the thickness of the speaker assembly 10. Accordingly, sound pressure generated by the diaphragm 90 may be maximized.

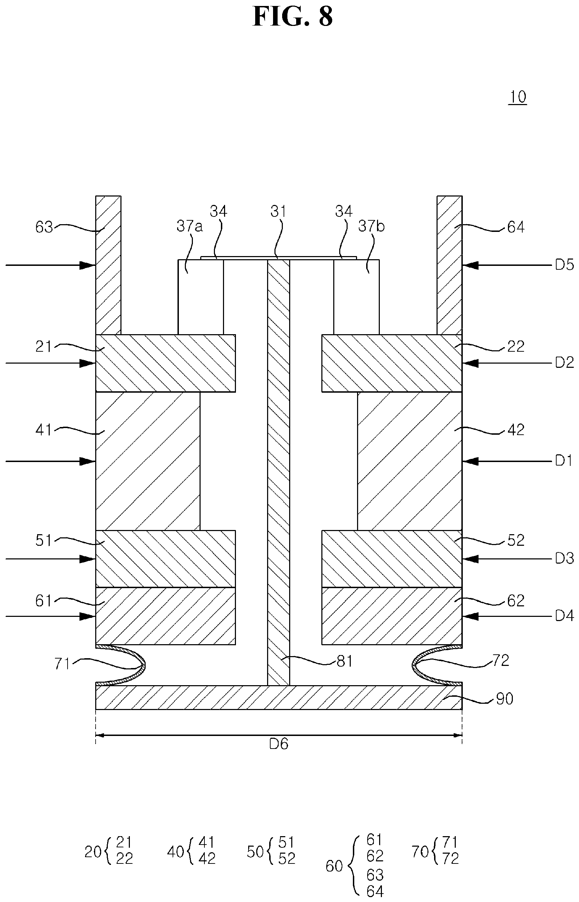

Referring to FIG. 8, the bobbin 81 may move from the front frames 61 and 62 toward the rear frames 63 and 64. As the bobbin 81 moves, the diaphragm 90 may move closer to the front frames 61 and 62, and the speaker edge 70 may be compressed. At the same time, the circles 37a and 37b of the damper 30 may be stretched in a longitudinal direction of the bobbin 81, such that a range of motion of the circles 37a and 37b of the damper 30 may be increased, and thus the amplitude of the diaphragm 90 may be increased.

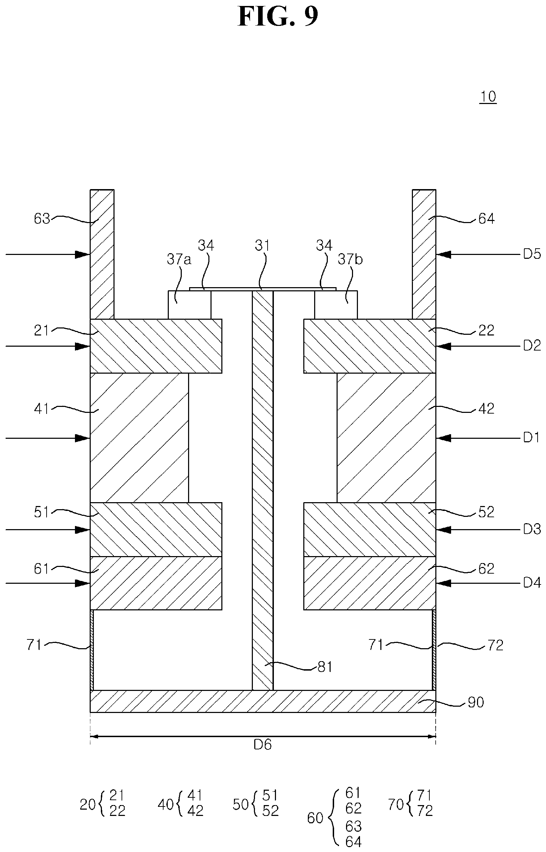

Referring to FIG. 9, the bobbin 81 may move from the rear frames 63 and 64 toward the front frames 61 and 62. As the bobbin 81 moves, the diaphragm 90 may move further away from the front frames 61 and 62, and the speaker edge 70 may be stretched. At the same time, the circles 37a and 37b of the damper 30 may be compressed in a longitudinal direction of the bobbin 81, such that a range of motion of the circles 37a and 37b of the damper 30 may be increased, and thus the amplitude of the diaphragm 90 may be increased.

Referring to FIGS. 1 to 9, the speaker assembly includes: a pair of magnets 40 facing each other; a bobbin 81 disposed between the pair of magnets 40 and formed in a shape of a plate that extends long; a coil 82 formed on at least one surface of the bobbin; a diaphragm 90 fixed to one side of the bobbin 81, and extending in a direction intersecting a longitudinal direction of the bobbin 81; a frame 60 disposed between the pair of magnets 40 and the diaphragm 90; and a speaker edge 70 disposed between the frame 60 and the diaphragm 90, having one end fixed to the frame 60 and the other end fixed to the diaphragm 90, and being convexly curved toward the bobbin 81.

The speaker assembly further includes a damper 30 disposed to face the frame 60 with respect to the pair of magnets 40, fixed to the other side of the bobbin 81 which faces the one side of the bobbin 81, and providing elasticity to the bobbin 81.

The damper includes a center plate 31 extending long along the other side of the bobbin 81, and fixed to the other side of the bobbin 81; bridges 32, 33, and 34 disposed across the center plate 31 and fixed to the center plate 31; and a plurality of circles 35, 36, and 37 fixed to both ends of the bridges 32, 33, and 34 and disposed to face each other with respect to the center plate 31.

The speaker assembly may further include a rear plate 20 disposed between the pair of magnets 40 and the plurality of circles 35, 36, and 37, and fixed to the pair of magnets 40 and the plurality of circles 35, 36, and 37.

The speaker edge 70 may include: a first speaker edge 71 having one end fixed to one side of the diaphragm 90 and the other end fixed to the frame 60, and being convexly curved toward the bobbin 81; and a second speaker edge 72 having one end fixed to the other side of the diaphragm 90, which faces the one side of the diaphragm 90, and the other end fixed to the frame 60, and being convexly curved toward the bobbin 81.

The first speaker edge 71 may be symmetrical to the second speaker edge 72 with respect to the bobbin 81.

The rear plate 20 may include: a first rear plate 21 disposed between one of the pair of magnets 40 and one of the plurality of circles 35, 36, and 37; and a second rear plate 22 disposed between the other one of the pair of magnets 40 and another one of the plurality of circles 35, 36, and 37, wherein the first rear plate 21 may include: a first surface connected to one of the pair of magnets 40; and a second surface connected to one of the plurality of circles 35, 36, and 37, wherein the first surface and the second surface may face each other.

The diaphragm 90 may include: a first long side connected to the first speaker edge 71; a second long side connected to the second speaker edge 72; a first short side connecting one end of the first long side and one end of the second long side; and a second short side connecting the other end of the first long side and the other end of the second long side, and facing the first short side.

The display device includes : a display panel 110; a frame 120 connected to the display panel 110; and the speaker assembly of Claim 1, which is disposed at a position adjacent to a lower end of the frame 120.

The diaphragm 90 may have a length in a left-right direction of the display panel 110 and may have a width in a thickness direction of the display panel 110.

The speaker assembly, and the display device including the same according to the present disclosure have the following effects.

According to at least one embodiment of the present disclosure, there is provided a speaker assembly capable of providing high sound quality.

According to at least one embodiment of the present disclosure, there is provided a speaker assembly having a slim structure while maintaining a high sound pressure level.

According to at least one embodiment of the present disclosure, there is provided a speaker assembly capable of increasing the amplitude of the speaker.

The additional scope of applicability of the present disclosure will be apparent from the above detailed description. However, those skilled in the art will appreciate that various modifications and alterations are possible, without departing from the scope of the appended claims, and therefore it should be understood that the detailed description and specific embodiments, such as the preferred embodiments of the present disclosure, are provided only for illustration.

Certain embodiments or other embodiments of the disclosure described above are not mutually exclusive or distinct from each other.

## Claims

1. A speaker assembly, comprising:
a pair of magnets (40) facing each other;
a bobbin (81) disposed between the pair of magnets (40) and formed in a shape of a plate that extends long;
a coil (82) formed on at least one surface of the bobbin (81);
a diaphragm (90) fixed to one side of the bobbin (81), and extending in a direction intersecting a longitudinal direction of the bobbin (81);
a frame (60) disposed between the pair of magnets (40) and the diaphragm (90); and
a speaker edge (70) having one end fixed to the frame (60) and the other end fixed to the diaphragm (90),
a damper (30) opposite to the frame (60) with respect to the pair of magnets (40), fixed to the other side of the bobbin (81) which is opposite to the one side of the bobbin (81), and providing elasticity to the bobbin (81),
wherein the speaker edge (70) is disposed between the frame (60) and the diaphragm (90) in the longitudinal direction of the bobbin (81) and is convexly curved toward the bobbin (81),
wherein the damper (30) comprises:
a center plate (31) extending long along the other side of the bobbin (81) and fixed to the other side of the bobbin (81);
bridges (32, 33, 34) disposed across the center plate (31) and fixed to the center plate (31); and
a plurality of circles (35, 36, 37) fixed to both ends of the bridges (32, 33, 34) and disposed opposite to each other with respect to the center plate (31).

2. The speaker assembly of claim 1, further comprising a rear plate (20) disposed between the pair of magnets (40) and the plurality of circles (35, 36, 37), and fixed to the pair of magnets (40) and the plurality of circles (35, 36, 37) .

3. The speaker assembly of claim 2, wherein the speaker edge (70) comprises:
a first speaker edge (71) having one end fixed to one side of the diaphragm (90) and the other end fixed to the frame (60), and being convexly curved toward the bobbin (81); and
a second speaker edge (72) having one end fixed to the other side of the diaphragm (90), which faces the one side of the diaphragm (90), and the other end fixed to the frame (60), and being convexly curved toward the bobbin (81).

4. The speaker assembly of claim 3, wherein the first speaker edge (71) is symmetrical to the second speaker edge (72) with respect to the bobbin (81).

5. The speaker assembly of claim 4, wherein the rear plate (20) comprises:
a first rear plate (21) disposed between one of the pair of magnets (40) and one of the plurality of circles (35, 36, 37); and
a second rear plate (22) disposed between the other one of the pair of magnets (40) and another one of the plurality of circles (35, 36, 37),
wherein the first rear plate (21) comprises:
a first surface connected to one of the pair of magnets (40); and
a second surface connected to one of the plurality of circles (35, 36, 37),
wherein the first surface and the second surface face each other.

6. The speaker assembly of claim 5, wherein the diaphragm (90) comprises:
a first long side connected to the first speaker edge (71) ;
a second long side connected to the second speaker edge (72);
a first short side connecting one end of the first long side and one end of the second long side; and
a second short side connecting the other end of the first long side and the other end of the second long side, and facing the first short side.

7. A display device, comprising:
a display panel (110);
a frame (120) connected to the display panel (110); and
the speaker assembly of any one of Claims 1 to 6, which is disposed at a position adjacent to a lower end of the frame (120).

8. The display device of claim 7, wherein the diaphragm (90) has a length in a left-right direction of the display panel (110) and has a width in a thickness direction of the display panel (110).

## Patentansprüche

1. Lautsprecheranordnung, die Folgendes umfasst:
ein Paar Magnete (40), die einander zugewandt sind;
einen Spulenträger (81), der zwischen dem Paar Magnete (40) angeordnet ist und in Form einer Platte, die sich lang erstreckt, gebildet ist;
eine Spule (82), die auf mindestens einer Oberfläche des Spulenträgers (81) gebildet ist;
eine Membran (90), die an einer Seite des Spulenträgers (81) befestigt ist und sich in einer Richtung erstreckt, die eine Längsrichtung des Spulenträgers (81) schneidet;
einen Rahmen (60), der zwischen dem Paar Magnete (40) und der Membran (90) angeordnet ist; und
eine Lautsprecherkante (70) deren eines Ende an dem Rahmen (60) befestigt ist und deren anderes Ende an der Membran (90) befestigt ist,
einen Dämpfer (30), der in Bezug auf das Paar Magnete (40) gegenüber von dem Rahmen (60) an der anderen Seite des Spulenträgers (81), die der einen Seite des Spulenträgers (81) gegenüberliegt, befestigt ist und dem Spulenträger (81) Elastizität bereitstellt,
wobei die Lautsprecherkante (70) in der Längsrichtung des Spulenträgers (81) zwischen dem Rahmen (60) und der Membran (90) angeordnet ist und in Richtung des Spulenträgers (81) konvex gekrümmt ist,
wobei der Dämpfer (30) Folgendes umfasst:
eine mittige Platte (31), die sich entlang der anderen Seite des Spulenträgers (81) lang erstreckt und an der anderen Seite des Spulenträgers (81) befestigt ist;
Stege (32, 33, 34), die über die mittige Plate (31) hinweg angeordnet und an der mittigen Platte (31) befestigt sind; und
eine Vielzahl von Kreisen (35, 36, 37), die an beiden Enden der Stege (32, 33, 34) befestigt und in Bezug auf die mittige Platte (31) gegenüber voneinander angeordnet sind.

2. Lautsprecheranordnung nach Anspruch 1, ferner umfassend eine hintere Platte (20), die zwischen dem Paar Magnete (40) und der Vielzahl von Kreisen (35, 36, 37) angeordnet und an dem Paar Magnete (40) und der Vielzahl von Kreisen (35, 36, 37) befestigt ist.

3. Lautsprecheranordnung nach Anspruch 2, wobei die Lautsprecherkante (70) Folgendes umfasst:
eine erste Lautsprecherkante (71), deren eines Ende an einer Seite der Membran (90) befestigt ist und deren anderes Ende an dem Rahmen (60) befestigt ist, und die in Richtung des Spulenträgers (81) konvex gekrümmt ist; und
eine zweite Lautsprecherkante (72), deren eines Ende an der anderen Seite der Membran (90), die der einen Seite der Membran (90) zugewandt ist, befestigt ist und deren anderes Ende an dem Rahmen (60) befestigt ist und die in Richtung des Spulenträgers (81) konvex gekrümmt ist.

4. Lautsprecheranordnung nach Anspruch 3, wobei die erste Lautsprecherkante (71) in Bezug auf den Spulenträger (81) zu der zweiten Lautsprecherkante (72) symmetrisch ist.

5. Lautsprecheranordnung nach Anspruch 4, wobei die hintere Platte (20) Folgendes umfasst:
eine erste hintere Platte (21), die zwischen einem des Paars Magnete (40) und einem der Vielzahl von Kreisen (35, 36, 37) angeordnet ist; und
eine zweite hintere Platte (22), die zwischen dem anderen des Paars Magnete (40) und einem anderen der Vielzahl von Kreisen (35, 36, 37) angeordnet ist,
wobei die erste hintere Platte (21) Folgendes umfasst:
eine erste Oberfläche, die mit einem des Paars Magnete (40) verbunden ist; und
eine zweite Oberfläche, die mit einem der Vielzahl von Kreisen (35, 36, 37) verbunden ist,
wobei die erste Oberfläche und die zweite Oberfläche einander zugewandt sind.

6. Lautsprecheranordnung nach Anspruch 5, wobei die Membran (90) Folgendes umfasst:
eine erste lange Seite, die mit der ersten Lautsprecherkante verbunden ist;
eine zweite lange Seite, die mit der zweiten Lautsprecherkante (72) verbunden ist;
eine erste kurze Seite, die ein Ende der ersten langen Seite und ein Ende der zweiten langen Seite verbindet; und
eine zweite kurze Seite, die das andere Ende der ersten langen Seite und das andere Ende der zweiten langen Seite verbindet und der ersten kurzen Seite zugewandt ist.

7. Anzeigevorrichtung, die Folgendes umfasst:
ein Display (110);
einen Rahmen (120), der mit dem Display (110) verbunden ist; und
die Lautsprecheranordnung nach einem der Ansprüche 1 bis 6, die an einer einem unteren Ende des Rahmens (120) benachbarten Stelle angeordnet ist.

8. Anzeigevorrichtung nach Anspruch 7, wobei die Membran (90) eine Länge in einer Links-Rechts-Richtung des Displays (110) aufweist und eine Breite in einer Dickenrichtung des Displays (110) aufweist.

## Revendications

1. Ensemble haut-parleur, comprenant :
une paire d'aimants (40) se faisant face l'un l'autre ;
une bobine (81) disposée entre la paire d'aimants (40) et formée sous la forme d'une plaque qui s'étend longitudinalement ;
un enroulement (82) formé sur au moins une surface de la bobine (81) ;
un diaphragme (90) fixé sur un côté de la bobine (81), et s'étendant dans une direction coupant une direction longitudinale de la bobine (81) ;
un cadre (60) disposé entre la paire d'aimants (40) et le diaphragme (90) ; et
un bord de haut-parleur (70) présentant une extrémité fixée au cadre (60) et l'autre extrémité fixée au diaphragme (90),
un amortisseur (30) disposé à l'opposé du cadre (60) par rapport à la paire d'aimants (40), fixé à l'autre côté de la bobine (81) qui est disposé à l'opposé du côté de la bobine (81), et fournissant une élasticité à la bobine (81),
dans lequel le bord de haut-parleur (70) est disposé entre le cadre (60) et le diaphragme (90) dans la direction longitudinale de la bobine (81) et est courbé de manière convexe vers la bobine (81),
dans lequel l'amortisseur (30) comprend :
une plaque centrale (31) s'étendant le long de l'autre côté de la bobine (81), et fixée à l'autre côté de la bobine (81) ;
des ponts (32, 33, 34) disposés à travers la plaque centrale (31) et fixés à la plaque centrale (31) ; et
une pluralité de cercles (35, 36, 37) fixés aux deux extrémités des ponts (32, 33, 34) et disposés à l'opposé des uns des autres par rapport à la plaque centrale (31).

2. Ensemble haut-parleur selon la revendication 1, comprenant en outre une plaque arrière (20) disposée entre la paire d'aimants (40) et la pluralité de cercles (35, 36, 37), et fixée à la paire d'aimants (40) et à la pluralité de cercles (35, 36, 37).

3. Ensemble haut-parleur selon la revendication 2, dans lequel le bord de haut-parleur (70) comprend :
un premier bord de haut-parleur (71) présentant une extrémité fixée à un côté du diaphragme (90) et l'autre extrémité fixée au cadre (60), et étant incurvé de manière convexe vers la bobine (81) ; et
un deuxième bord de haut-parleur (72) présentant une extrémité fixée à l'autre côté du diaphragme (90), qui fait face au côté du diaphragme (90), et l'autre extrémité fixée au cadre (60), et étant incurvé de manière convexe vers la bobine (81) .

4. Ensemble haut-parleur selon la revendication 3, dans lequel le premier bord de haut-parleur (71) est symétrique au deuxième bord de haut-parleur (72) par rapport à la bobine (81) .

5. Ensemble haut-parleur selon la revendication 4, dans lequel la plaque arrière (20) comprend :
une première plaque arrière (21) disposée entre un de la paire d'aimants (40) et un de la pluralité de cercles (35, 36, 37) ; et
une deuxième plaque arrière (22) disposée entre l'autre aimant de la paire d'aimants (40) et un autre cercle de la pluralité de cercles (35, 36, 37),
dans lequel la première plaque arrière (21) comprend :
une première surface reliée à un de la paire d'aimants (40) ; et
une deuxième surface reliée à un de la pluralité de cercles (35, 36, 37),
dans lequel la première surface et la deuxième surface se font face l'une l'autre.

6. Ensemble haut-parleur selon la revendication 5, dans lequel le diaphragme (90) comprend :
un premier côté long relié au premier bord de haut-parleur (71) ;
un deuxième côté long relié au deuxième bord de haut-parleur (72) ;
un premier côté court reliant une extrémité du premier côté long et une extrémité du deuxième côté long ; et
un deuxième côté court reliant l'autre extrémité du premier côté long et l'autre extrémité du deuxième côté long, et faisant face au premier côté court.

7. Dispositif d'affichage comprenant :
un panneau d'affichage (110) ;
un cadre (120) relié au panneau d'affichage (110) ; et
l'ensemble haut-parleur selon l'une quelconque des revendications 1 à 6, qui est disposé sur une position de manière adjacente à une extrémité inférieure du cadre (120).

8. Dispositif d'affichage selon la revendication 7, dans lequel le diaphragme (90) présente une longueur dans une direction gauche-droite du panneau d'affichage (110) et présente une largeur dans une direction d'épaisseur du panneau d'affichage (110).
